Europäisches Patentamt

European Patent Office

Office européen des brevets

(11) Numéro de publication: **0 190 613 B1**

## FASCICULE DE BREVET EUROPEEN

(45) Date de publication de fascicule du brevet:
06.03.91

(51) Int. Cl.5: **H03D 9/04**, H01P 7/10

(21) Numéro de dépôt: 86100846.4

(22) Date de dépôt: 23.01.86

(54) Discriminateur hyperfréquences et dispositif d'utilisation.

(30) Priorité: 29.01.85 FR 8501207

(43) Date de publication de la demande:
13.08.86 Bulletin 86/33

(45) Mention de la délivrance du brevet:
06.03.91 Bulletin 91/10

(84) Etats contractants désignés:
BE DE FR GB IT

(56) Documents cités:
EP-A- 0 091 201     DE-B- 1 018 480
FR-A- 2 115 402     GB-A- 1 576 761
US-A- 3 742 390     US-A- 4 019 161

RCA TECHNICAL NOTES, no. 1006, 9 avril
1975, pages 1 et 2, Princeton, N.J., US; A.
SCHWARZMANN: "Microstrip discriminator"

(73) Titulaire: ALCATEL TRANSMISSION PAR FAIS-
CEAUX HERTZIENS A.T.F.H.
55, rue Greffulhe
F-92300 Levallois-Perret Cédex(FR)

(72) Inventeur: Argintaru, Lazare
103, avenue du Belvédère
F-93310 Le Pre Saint Gervais(FR)
Inventeur: Hebrard, Denis
4, rue Edouard Vaillant
F-92300 Levallois Perret(FR)

(74) Mandataire: Weinmiller, Jürgen et al
Lennéstrasse 9 Postfach 24
W-8133 Feldafing(DE)

## Description

La présente invention se rapporte à un discriminateur de fréquences, c'est-à-dire un dispositif électronique transformant une modulation de fréquence en signal démodulé basse-fréquence, pour ondes hyperfréquences, ainsi qu'à quelques dispositifs d'utilisation d'un tel discriminateur.

D'une manière générale, un discriminateur de fréquences est un dispositif, destiné à transformer une modulation de fréquence en signal démodulé basse-fréquence, qui est susceptible d'un certain nombre d'applications, dont les plus courantes sont la démodulation en Fréquence Intermédiaire et la Commande Automatique de Fréquence d'un oscillateur, dans lequel le discriminateur est également amené à fonctionner en Fréquence Intermédiaire.

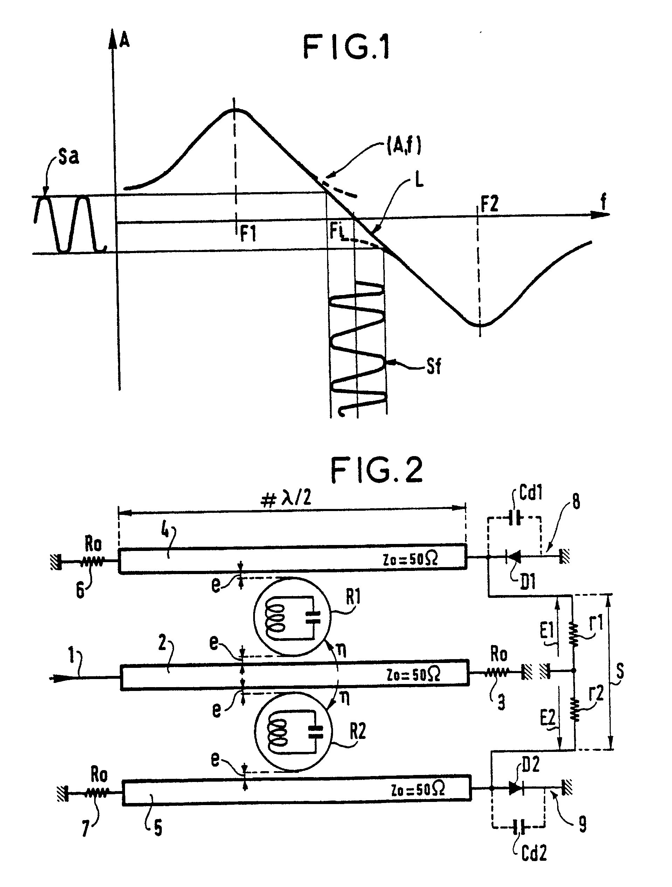

Pour ces fréquences dites "intermédiaires", d'une valeur de l'ordre de quelques dizaines de Mégahertz par exemple pour un émetteur ou un récepteur d'ondes en hyperfréquences, il est très classique d'utiliser le "discriminateur de TRAVIS", comportant deux circuits oscillants accordés sur deux fréquences différentes $F_1$ et $F_2$, situées de part et d'autre de la Fréquence Intermédiaire $F_i$, et deux circuits de détections à diode suivie d'un circuit de filtrage à capacité et résistance de charge tous deux en parallèle. En branchant les deux résistances de charge en série-opposition, et en prenant la tension de sortie aux bornes de la charge totale ainsi obtenue, on obtient une tension ayant la forme classique de la caractéristique Amplitude-fréquence A (f) rappelée sur la figure 1 annexée. Un signal $S_f$ porté par l'onde porteuse $F_i$ et modulé en fréquence est donc ainsi, grâce au discriminateur de courbe de réponse A (f), transformé en signal $S_a$ modulé en amplitude, comme rappelé schématiquement sur la figure 1.

Des réalisations de discriminateurs de fréquences fonctionnant en hyperfréquences ont été faites, il y a fort longtemps, comme en témoigne l'ouvrage de C.G. Montgomery "Technique of Microwave Measurements"; Mc GRAW-HILL BOOK Co, INc., 1947, pages 63 à 66. Il s'agissait alors de circuits hyperfréquences à Tés magiques, cavité hyperfréquences métallique et guides d'ondes, qui avaient la propriété de reproduire une courbe Amplitude/fréquences semblable, en hyperfréquences, à celle du discriminateur de TRAVIS.

De tels discriminateurs n'ont pas débouché sur des réalisations industrielles car ils sont complexes à réaliser, encombrants, coûteux, et très sensibles aux écarts de température. Ces inconvénients ont alors dissuadé l'homme de métier d'utiliser, pour des démodulateurs ou des dispositifs de Commande Automatique de Fréquence par exemple, d'une façon générale des discriminateurs hyperfréquences, et ont ainsi pendant ces trente dernières années environ, créé en la matière un véritable préjugé, de sorte que les discriminateurs de fréquence ont été réalisés dans le passé uniquement en Fréquence Intermédiaire.

On connaît par ailleurs, depuis avant 1940 (voir le "Journal of Applied Physics", vol. 10, juin 1939, pages 391 à 398) les résonateurs diélectriques pour hyperfréquences. De tels résonateurs diélectriques ont été utilisés dès le début des années 1960 dans des applications aux micro-ondes ; voir en particulier :
- Proceedings IRE, vol. 50, Octobre 1962, pages 2081 à 2092
- IEEE Transactions on Microwave Theory and Techniques, vol. MTT-12, Septembre 1964, pages 549 et 550
- IEEE Transactions on Microwave Theory and Techniques, vol. MTT-13, Mars 1965, page 256.

Plus récemment encore sont apparues des réalisations d'oscillateurs hyperfréquences comportant, en guise de circuit oscillant, un résonateur diélectrique.

De tels faits n'ont cependant pas pu suffire, jusqu'à ce jour, à vaincre ce très fort préjugé de l'homme de métier écartant de son esprit l'utilisation, directement en hyperfréquences, d'un discriminateur de fréquences, et il ne lui est donc pas venu à l'esprit que le résonateur diélectrique, par sa très petite taille, pouvait permettre la réalisation d'un discriminateur hyperfréquences ne présentant pas les inconvénients des discriminateurs hyperfréquences de l'art antérieur. Il faut ajouter à ceci que les résonateurs diélectriques ont une dérive importante en température, comme en témoigne la littérature ci-dessus mentionnée, et que l'homme de métier est habitué à la nécessité, pour un discriminateur de fréquences, d'une courbe de réponse Amplitude/fréquence particulièrement stable en fonction de la température.

Le document DE-B-1 018 480 décrit un dispositif discriminateur pour très hautes fréquences, comportant:
- un tronçon de ligne, excité à certaines fréquences, connecté à une première extrémité à un générateur d'impédance interne Z et à une seconde extrémité sur une impédance de même valeur Z ;
- un circuit réfléchissant certaines fréquences, situé près de cette seconde extrémité du tronçon de ligne ;
- un circuit piège, qui est accordé sur la fréquence médiane fo dudit dispositif discriminateur disposé sur le tronçon de ligne ;
- deux coupleurs de direction reliés respectivement au travers de deux redresseurs à deux circuits de détection RC comportant chacun une sortie, la sortie dudit dispositif discriminateur étant obtenue entre les sorties respectives de ces deux circuits de détection RC.

Il est aussi fait référence au document US-A-3 742 390 qui divulgue l'utilisation de résonateurs diélectriques comme coupleurs entre des lignes à microruban.

Un article paru dans "RCA technical notes" n° 1006 du 9 avril 1975 pages 1 et 2 (Princeton N.J. US) de A. Schwarzmann intitulé "Microstrip discriminator" décrit un discriminateur "microstrip" formé d'une structure couplée comprenant trois lignes à microruban couplées entre elles et séparées d'un conducteur de masse par un substrat diélectrique. Les signaux hyperfréquences d'entrée modulés en fréquence sont appliqués à une extrémité de la première ligne à microruban qui est la ligne centrale. La seconde ligne à microruban est égale au quart de la longueur d'onde à une fréquence inférieure à la fréquence porteuse centrale du signal d'entrée. La troisième ligne à microruban est égale au quart de la longueur d'onde à une fréquence supérieure à la fréquence porteuse centrale. Ces deux dernières lignes sont couplées à la masse par leur première extrémités. Un première diode a sa cathode couplée à la première extrémité de la seconde ligne et son anode à la sortie au travers d'un premier filtre passe-bas. Une seconde diode a son anode couplée à la première extrémité de la troisième ligne et sa cathode couplée à la sortie au travers d'un second filtre passe-bas.

Par contre l'invention se rapporte à un discriminateur de fréquence pour onde en hyperfréquences, comportant sur un même substrat :

- au moins une première ligne d'entrée à au moins un microruban pour une onde hyperfréquences à discriminer,
- au moins deux autres lignes secondaires à microruban disposées parallèlement de part et d'autre de la première ligne,
- un couple de circuits de détection formés respectivement de diodes hyperfréquences connectées en série-opposition ;

caractérisé en ce que toutes les lignes sont identiques, et de longueur approximativement égale à la moitié de la longueur d'onde du signal d'entrée, chaque ligne étant fermée à une extrémité par une résistance d'adaptation ; en ce que ledit discriminateur comprend au moins un couple de résonateurs diélectriques hyperfréquences de fréquences de résonance situées respectivement de part et d'autre de la fréquence de l'onde hyperfréquence à discriminer ; un des résonateurs étant placé entre la ligne d'entrée et l'une des lignes secondaires, à proximité immédiate de celles-ci et couplé à celles-ci, un autre résonateur étant placé entre la ligne d'entrée et une autre ligne secondaire, à proximité immédiate de celles-ci et couplé à celles-ci et en ce que les diodes de détection hyperfréquence sont connectées respectivement entre l'extrémité libre de chaque ligne secondaire et la masse, une résistance de charge étant branchée entre ladite extrémité et la masse, la tension de sortie d'onde hyperfréquence discriminée étant prise entre lesdites extrémités de ces lignes secondaires.

L'invention s'applique encore à un dispositif de Commande Automatique de Fréquence d'un oscillateur hyperfréquences, utilisant un tel discriminateur hyperfréquences, et caractérisé en ce qu'il comporte :

- un dispositif de couplage d'ondes hyperfréquences placé en sortie dudit oscillateur
- un discriminateur hyperfréquences à résonateurs diélectriques, de fréquence centrale $F_o$ égale à celle dudit oscillateur, dont l'entrée est alimentée par la sortie dudit dispositif de couplage, et dont la sortie est reliée à une entrée de commande de fréquence dudit oscillateur.

Selon une forme de réalisation particulièrement avantageuse, un tel dispositif de Commande Automatique de Fréquence est par ailleurs caractérisé en ce qu'il utilise un discriminateur hyperfréquences équipé d'au moins un couple de résonateurs diélectriques dont les fréquences de résonances varient en sens inverses lorsque la température varie. On évite ainsi, dans ce type d'utilisation, l'utilisation d'un dispositif annexe de contrôle de température pour le discriminateur.

L'invention concerne en outre un démodulateur d'onde hyperfréquences modulée en fréquence, utilisant un tel discriminateur hyperfréquences, caractérisé en ce qu'il comporte successivement :

- un limiteur d'amplitude pour ondes hyperfréquences
- un discriminateur hyperfréquences à résonateurs diélectriques.

Selon une forme avantageuse de réalisation, un tel démodulateur est en outre caractérisé en ce que ledit limiteur d'amplitude comporte un ou plusieurs éléments en série comportant chacun :

- un circulateur hyperfréquences à au moins trois voies
- une entrée de l'onde hyperfréquence à démoduler sur la borne d'entrée dudit circulateur
- une première sortie, dans le sens de circulation, dudit circulateur vers un oscillateur hyperfréquences synchronisé, ladite sortie formant entrée pour l'onde en retour dudit oscillateur synchronisé
- une deuxième sortie, placée après ladite première sortie dans le sens de circulation, dudit circulateur, formant sortie de l'onde hyperfréquence limitée en amplitude.

L'invention se rapporte en outre à un récepteur pour onde hyperfréquence modulée en fréquence, caractérisé en ce qu'il comporte succes sivement :

- un dispositif de filtrage de l'onde à fréquence porteuse $F_1$ que l'on veut recevoir
- un démodulateur hyperfréquences tel que ci-dessus défini.

L'invention se rapporte enfin à un récepteur multicanaux pour ondes hyperfréquences modulées en fréquence, comportant un démodulateur tel que ci-dessus défini, caractérisé en ce qu'il comporte :

- un dispositif de filtrage de l'onde à fréquence porteuse $F_1$ que l'on veut recevoir
- ledit démodulateur hyperfréquences
- un dispositif de génération d'une tension continue $V_1$ égale à la tension continue superposée, en sortie dudit démodulateur, à l'onde variable démodulée $v_1$ correspondant à l'onde à fréquence porteuse $F_1$
- un dispositif de soustraction de la tension ($V_1$ + $v_1$) en sortie dudit démodulateur et de ladite tension continue $V_1$.

Avantageusement, un tel récepteur multicanaux est en outre caractérisé en ce qu'il est équipé de moyens de sélection automatique de la fréquence $F_1$ que l'on veut recevoir, à partir de ladite tension continue $V_1$.

Selon une forme particulière de réalisation, un tel récepteur multicanaux est avantageusement équipé de moyens de commande automatique dudit dispositif de filtrage par ladite tension continue $V_1$.

L'invention sera mieux comprise à l'aide de la description suivante de quelques exemples non limitatifs de réalisation, en référence aux dessins annexés dans lesquels :

- la figure 1 est un rappel de la courbe de réponse tensions/fréquences d'un discriminateur de fréquences de TRAVIS
- la figure 2 est un schéma électrique du discriminateur hyperfréquences de l'invention
- la figure 3 est un schéma, en perspective avec arrachement partiel, d'implantation pratique du discriminateur de la figure 2
- la figure 4 illustre la déformation, en fonction de la température, de la caractéristique de réponse du discriminateur de la figure 3
- la figure 5 est un schéma de principe d'un dispositif, selon l'invention, de Commande Automatique de Fréquence d'un oscillateur hyperfréquences
- la figure 6 est un schéma de réalisation du dispositif de la figure 5
- la figure 7 représente schématiquement un démodulateur, selon l'invention, pour onde hyperfréquence modulée en fréquence
- la figure 8 est une représentation schématique d'un récepteur, conforme à l'invention, pour onde hyperfréquence modulée en fréquence

- la figure 9 est un diagramme explicatif relatif à la possibilité d'une réception multicanaux à l'aide du discriminateur de l'invention
- la figure 10 est une représentation schématique d'un récepteur multicanaux, conforme à l'invention, pour ondes hyperfréquences modulées en fréquences.

La figure 1, déjà décrite ci-dessus, est une caractéristique de réponse tensions (A)/fréquences (f) d'un discriminateur de TRAVIS. La partie utile d'une telle caractéristique est la partie linéaire $L_1$ comprise entre les fréquences $F_1$ et $F_2$ d'accord des deux circuits résonnants utilisés. Une telle partie linéaire se caractérise classiquement par ses qualités de linéarité et de pente qui, comme il est bien connu du spécialiste, sont antinomiques.

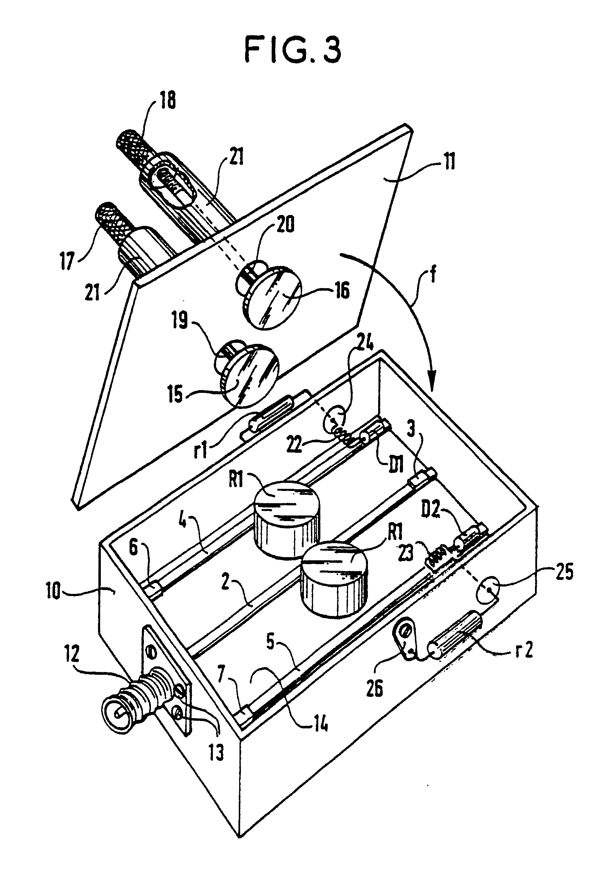

La figure 2 est un schéma électrique du discriminateur hyperfréquences de l'invention, qui est en fait une tranposition en hyperfréquences, par utilisation de résonateurs diélectriques et de lignes à microrubans, du discriminateur de TRAVIS couramment utilisé pour les fréquences beaucoup plus basses.

Sur cette figure, la référence 1 désigne l'entrée, sur le discriminateur, de l'onde hyperfréquence à Fréquence $F_o$ modulée en fréquence. Par exemple, il s'agit d'une onde dont la fréquence porteuse est de 7 Gigahertz, modulée en fréquence dans un canal de modulation d'une largeur totale de 50 Mégahertz. Comme on le voit sur le dessin, ce signal est reçu , dans le discriminateur de l'invention, sur une ligne d'entrée à microruban 2, d'une longueur approximativement égale à la moitié de la longueur d'onde $\lambda_o$ du signal d'entrée à fréquence $F_o$, et d'impédance caractéristique $Z_o$ égale à 50 ohms pour fixer les idées. A son autre extrémité, la ligne est bien entendu fermée par une résistance d'adaptation 3, de valeur $R_o$ égale à 50 ohms, dont l'autre extrémité est reliée à la masse. En variante, l'entrée 1 pourrait être couplée à deux lignes à microrubans fermées chacune sur une résistance d'adaptation, avec inter position, entre ces deux lignes et l'entrée 1 d'un diviseur de puissance.

La ligne 2 est, conformément à l'invention, couplée de part et d'autre à deux résonateurs diélectriques $R_1$ et $R_2$, par exemple à Titanate de Zirconium, selon un même coefficient de couplage $\eta$ qui dépend de la faible distance e (quelques dizièmes de millimètre) laissée entre la ligne 2 et chacun des résonateurs $R_1$ et $R_2$.

Chaque résonateur $R_1$ et $R_2$ est respectivement accordé sur une fréquence $F_1$ inférieure à la fréquence $F_o$ et sur une fréquence $F_2$ supérieure à la fréquence $F_o$. Par exemple, pour la fréquence porteuse $F_o$ de 7 Gigahertz citée ci-dessus, la

fréquence $F_1$ est égale à 6 Gigahertz et la fréquence $F_2$ est égale à 8 Gigahertz, la bande de discrimination ($F_2 - F_1$) étant donc approximativement égale à 2 Gigahertz.

Comme on le voit sur le dessin, chaque résonateur diélectrique $R_1$, $R_2$, est également couplé respectivement à une autre ligne à microruban, respectivement 4 et 5, identiques chacune à la ligne d'entrée 2 et fermées chacune, comme représenté, à une de leurs deux extrémités, sur une résistance d'adaptation, respectivement 6 et 7, de valeur $R_o$ égale à l'impédance caractéristique $Z_o$ de chacune de ces lignes, c'est-à-dire 50 ohms dans l'exemple considéré.

Dans l'exemple représenté, la distance e laissée libre entre chaque résonateur $R_1$, $R_2$ et sa seconde ligne 4, 5 associée est égale à celle existant entre ceux-ci et la ligne d'entrée 2. Bien entendu, elles pourraient être différentes de celle-ci selon le cas.

A leur autre extrémité, les lignes 4 et 5 sont chacune refermées sur un circuit de détection hyperfréquences, respectivement 8 et 9, comportant une diode de détection hyperfréquences, respectivement $D_1$ et $D_2$, connectée entre ladite extrémité et la masse et présentant une capacité parasite en parallèle, $Cd_1$ et $Cd_2$ respectivement, et une résistance de charge, respectivement $r_1$ et $r_2$, d'une valeur de quelques kilohms par exemple, également branchée entre ladite extrémité et la masse. Il apparaît ainsi, aux bornes des résistances de charge $r_1$ et $r_2$, des tensions détectées $E_1$ et $E_2$ qui, si l'on prend comme représenté la tension de sortie S du discriminateur entre lesdites extrémités des lignes 4 et 5, sont en série-opposition.

Le fonctionnement du discriminateur de la figure 2 est identique, après transposition en hyperfréquences, à celui du discriminateur de TRAVIS, les résonateurs $R_1$ et $R_2$ y remplaçant les deux circuits résonnants classiques à self-induction et capacité, de sorte que la courbe de réponse du discriminateur de la figure 2 est celle de la figure 1, avec une fréquence inférieure $F_1$ égale à 6 Gigahertz, une fréquence supérieure $F_2$ égale à 8 Gigahertz, et une fréquence médiane $F_i$ devenant la fréquence $F_o$, égale à 7 Gigahertz dans l'exemple considéré.

La figure 3 est une représentation en perspective de la réalisation pratique du discriminateur de la figure 2.

Sur cette figure, la référence 10 désigne l'enceinte métallique parallélépipédique destinée à recevoir le discriminateur de l'invention et à être fermée, comme indiqué par la flèche f, par un couvercle métallique 11. La boîte 11, qui constitue la masse du dispositif, est de faibles dimensions à la fréquence de 7 Gigahertz considérée, par exemple ses dimensions sont de 25 x 25 x 20 millimètres.

L'entrée 1 de la figure 2 est matérialisée ici par une embase coaxiale 12 fixée sur la boîte 11 par des vis 13. Les résonateurs diélectriques $R_1$ et $R_2$, ainsi que les lignes à microrubans 5, 2, 4 sont respectivement collés et déposées sur un même substrat 14 en matière isolante, par exemple en Alumine.

Avantageusement, les résonateurs diélectriques $R_1$ et $R_2$ sont constitués chacun en un matériau qui, tout en étant par exemple du Titanate de Zirconium, ont chacun un coefficient de dilatation thermique inverse l'un de l'autre, ceci ayant été obtenu par un procédé chimique largement connu à l'heure actuelle. Par exemple, le résonateur $R_1$ se dilate lorsque sa température croît, de sorte que sa fréquence de résonance $F_1$ diminue, alors que le résonateur $R_2$ se rétrécit d'autant lorsque sa température croît, de sorte que sa fréquence de résonance $F_1$ augmente d'autant.

De manière classique pour les résonateurs diélectriques, des plongeurs métalliques 15 et 16, portés comme représenté par le couvercle 11, sont positionnés en regard de chacun des résonateurs $R_1$ et $R_2$ et permettent, par rotation des boutons moletés 17 et 18 associés, et donc enfoncement ou éloignement de chacun de ces plongeurs, de régler finement les fréquences de résonances F1 et F2 de chacun des résonateurs $R_1$ et $R_2$.

Avantageusement, chacun des plongeurs 15 et 16 peut être du type connu dit "à compensation mécanothermique", par exemple tel que décrit dans le brevet US-A-3.528.042. Pour ce faire, la tige (respectivement 19 et 20) de chacun des plongeurs 15 et 16 est constituée en un matériau, tel que de l'INVAR ou tel qu'un quartz inerte métallisé, inerte en fonction de la température, c'est-à-dire à coefficient de dilatation très faible, voire négligeable. Dans ces conditions, il apparaît que, lorsque par exemple la température croît, l'enceinte métallique tubulaire 21 de chaque plongeur s'allonge tandis que sa tige (19, 20) ne s'allonge pas, de sorte que chaque plongeur (15, 16) s'éloigne du résonateur diélectrique ($R_1$, $R_2$) associé, de sorte qu'il tend ainsi à augmenter sa fréquence de résonance, alors que celle-ci aurait dans cet exemple tendance à diminuer d'autant.

Ce dernier exemple est valable dans le cas où les deux résonateurs ($R_1$, $R_2$) ont des propriétés thermiques identiques. Dans le cas particulier, évoqué ci-dessus où l'un des résonateurs, $R_1$ par exemple, serait en matériau tel que sa fréquence de résonance décroisse lorsque la température croît, alors que l'autre résonateur, $R_2$ par exemple, serait en matériau tel que sa fréquence de résonance croisse lorsque la température croît, il faudrait que le second plongeur, 16 dans cet exemple, associé au second résonateur $R_2$, soit tel qu'il se rapproche de ce résonateur lorsque la température croît, c'est-à-dire qu'il soit par exemple porté par une tige 20 en métal ordinaire contenue dans une enceinte tubulaire 21 en matériau thermiquement inerte.

Sur la figure 3, on distingue encore, branchées comme sur la figure 2, les diodes de détection $D_1$ et $D_2$, ainsi que les résistances d'adaptation 3, 6 et 7. Comme on le voit sur le dessin, les diodes $D_1$ et $D_2$ sont connectées à leurs résistances de charge respectives $r_1$ et $r_2$ par l'intermédiaire de selfs de choc 22 et 23 et de traversées, isolantes par rapport à l'enceinte métallique 10, respectivement 24 et 25. Comme on le voit sur le dessin, la seconde extrémité de chacune des résistances $r_1$ et $r_2$ est respectivement soudée sur une cosse de masse telle que 26.

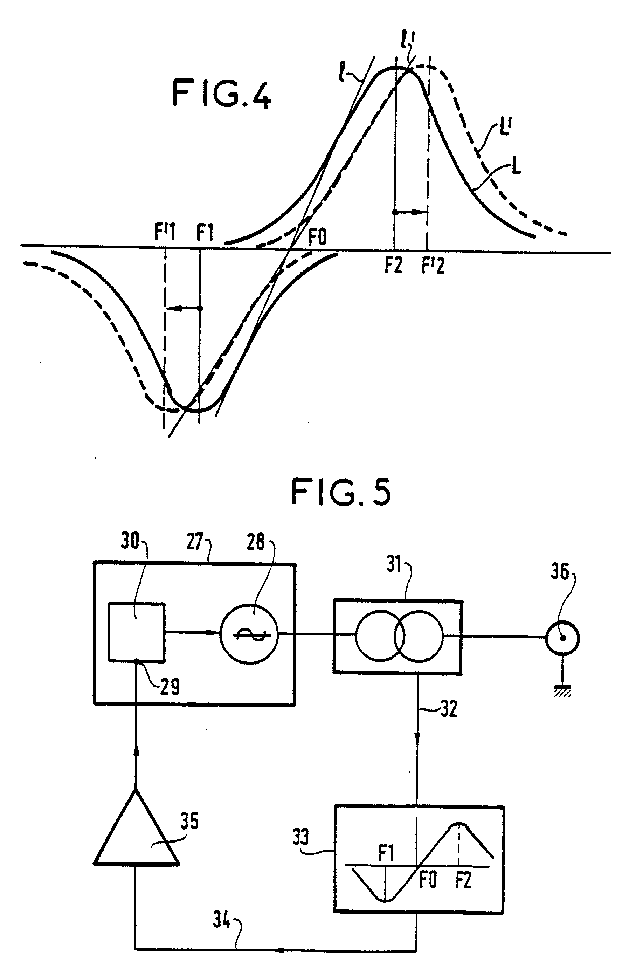

On a vu que, dans une forme avantageuse de réalisation du discriminateur de la figure 3, les résonateurs diélectriques $R_1$ et $R_2$ étaient en matériaux tels que leurs fréquences de résonance varient en sens inverses en fonction de la température. La figure 4 permet de comprendre l'effet avantageux obtenu grâce à cette disposition particulière.

Sur cette figure, on a représenté en traits pleins la caractéristique L obtenue à température ambiante, par exemple 20 degrés centigrade, et en pointillés la caractéristique L' obtenue à température supérieure à la température ambiante, par exemple à 70 degrés centigrade. Pour la caractéristique L', la fréquence de résonance $F_2$ du résonateur $R_2$ a augmenté jusqu'à $F'_2$, et la fréquence de résonance $F_1$ du résonateur $R_1$ a diminué d'autant jusqu'en $F'_1$. Les parties linéaires, situées entre les deux "bosses" de chacune des caractéristiques L et L' ont été représentées par les droites 1 et 1'.

On voit sur la figure 4 que, les deux bosses s'étant écartées symétriquement avec l'augmentation de la température, la fréquence centrale $F_o$ est restée inchangée. Seules les pentes des parties linéaires 1 et 1' sont différentes ce qui, pour certaines applications telle que, comme on le verra ultérieurement, la Commande Automatique de Fréquence, n'a pas d'importante primordiale.

On remarquera que la réalisation, telle que celle de la figure 3, d'un discriminateur selon l'invention conduit à un dispositif de très petite taille. Dans ces conditions, il est très aisé d'en obtenir une stabilisation en température en le plaçant dans une enceinte thermostatée à température constante, par exemple 75 degrés centigrade. Le four utilisé pourra alors être de très petites dimensions, donc d'implantation facile, et de très faible consommation énergétique. La solution de stabilisation par enceinte thermostatée, qui étaient pratiquement inconcevable avec les dispositifs encombrants à cavités métalliques, Tés magiques, et guides d'ondes de l'art antérieur, devient donc très concevable avec le dispositif de dimensions très réduites de l'invention.

Le discriminateur hyperfréquences de l'invention est susceptible d'entrer dans un certain nombre de réalisations nouvelles et particulièrement avantageuses. Sa pente, en raison du très fort coefficient de surtension inhérent aux résonateurs diélectriques, est considérablement plus élevée que celle des discriminateurs couramment utilisés en moyenne fréquence. Dans l'exemple de réalisation de la figure 3, on a relevé une pente de 0,25 Volts/Megahertz pour des fréquences $F_1$ et $F_2$ distantes de 20 Megahertz.

Ces chiffres élevés de pente nous permettent alors de réaliser, de manière simple car sans passage par un changement de fréquence, un dispositif de Commande Automatique de fréquence d'un oscillateur hyperfréquence, par exemple d'un oscillateur à bonne pureté spectrale tel qu'un Oscillateur à Résonateurs Diélectriques, ou D.R.O.

Par ailleurs, le fait de pouvoir obtenir, pour un discriminateur selon l'invention, une très grande différence entre les fréquences extrêmes de discrimination $F_2$ et $F_1$, de 2 Gigahertz par exemple, permet d'obtenir un dispositif de Commande Automatique de Fréquence toujours convergent lorsque la température varie. Ceci permet alors de supprimer les dispositifs de recherche, nécessaires dans les dispositifs de Commande Automatique de Fréquence de l'art antérieur, dispositifs de recherche qui sont particulièrement complexes et coûteux.

La figure 5 est une représentation par schémas-blocs d'un dispositif de Commande Automatique de Fréquence pour oscillateur hyperfréquence selon l'invention.

Sur cette figure, la référence 27 désigne un oscillateur, tel qu'un D.R.O., construit pour osciller à une fréquence $F_o$ de 7 Gigahertz par exemple. De manière classique, cet oscillateur comporte un circuit d'oscillation 28, dont la fréquence est commandable par une tension continue extérieure appliquée en 29 sur un circuit de commande 30, à diodes varactor par exemple.

En sortie de l'oscillateur 30 est placé un coupleur hyperfréquences 31 à quelques dBm qui dérive en 32 une faible puissance, de l'ordre du milliwatt, laquelle est appliquée à l'entrée d'un discriminateur 33 à résonateurs diélectriques de fréquence centrale $F_o$, tel que celui de la figure 3 équipé de résonateurs à dilatations thermiques inverses. Au cas où la fréquence de l'onde appliquée en 32 au discriminateur 33 s'écarte de la fréquence $F_o$, le discriminateur 33 sort en 34 une tension d'erreur, positive ou négative selon le cas, qui est appliquée, à travers un amplificateur analogique de mise à niveau 35, à l'entrée de commande 29 du dispositif à varactors 30, ramenant ainsi la fréquence de l'oscillateur 27 à sa valeur nominale $F_o$. Le signal à fréquence constante $F_o$ est alors relévé sur la sortie 36 de l'ensemble.

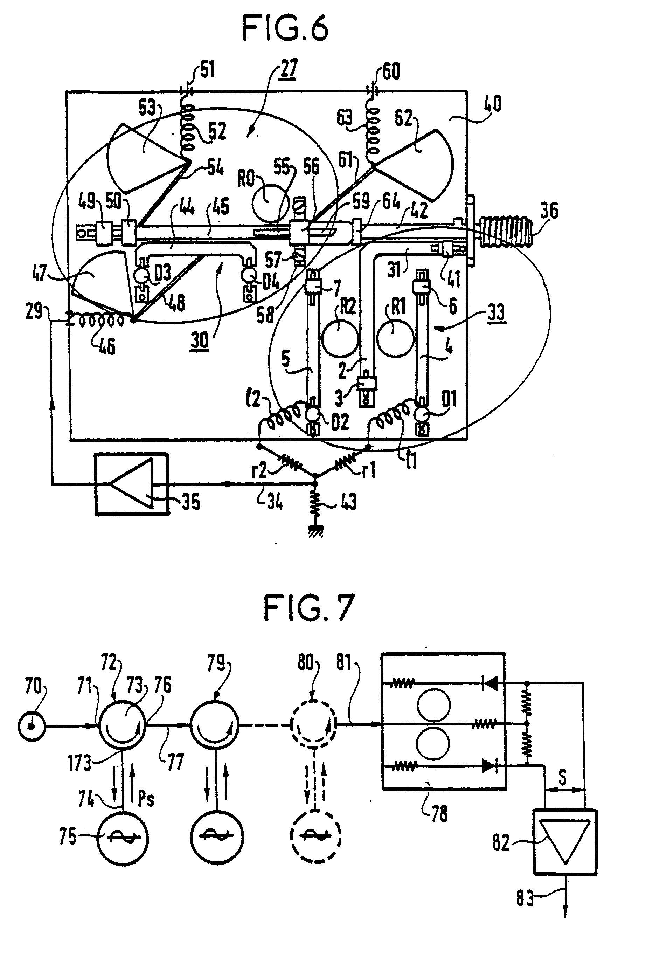

Sur la figure 6 on a représenté, à titre d'exemple indicatif un mode de réalisation pratique du dispositif de la figure 5.

Comme on le voit sur le dessin, on a positionné, sur un même substrat 40, en alumine isolante par exemple, à la fois la partie oscillateur 27 (entourée d'une ellipse en trait fin sur le dessin) et la partie discriminateur 33 (également entourée d'une ellipse en trait fin sur le dessin). Pour un maximum de clarté, les chiffres de référence qui correspondent aux éléments se retrouvant sur les figures 2 et 5 ont été repris tels quels sur cette figure 6 et ne seront donc pas décrits à nouveau. Le discriminateur 33 utilisé ici est donc identique à celui de la figure 2, aux selfs de choc basse-fréquence, $s_1$ et $s_2$ rajoutées entre les diodes $D_1$, $D_2$ et les résistances associées $r_1$, $r_2$, près.

Le coupleur 31 est constitué par une ligne à microrubans, fermée sur sa résistance d'adaptation 41 comme représenté, placée à proximité de la ligne à microruban 42 de sortie de l'oscillateur hyperfréquence 27, le niveau de couplage dépendant du niveau de puissance de sortie de l'oscillateur 27.

La sortie 34 du discriminateur 33 est ici prise, ce qui constitue une différence de détail avec ce qui est indiqué sur la figure 2, aux bornes d'une résistance 43 montée en étoile avec les résistances $r_1$ et $r_2$, le résultat électrique étant le même.

La sortie de l'amplificateur basse-fréquence 35 (amplificateur opérationnel par exemple) est connectée en 29 au circuit 30 de commande en tension de la fréquence de l'oscillateur 27. De manière très classique, ce circuit comporte deux diodes - varactor $D_3$ et $D_4$ réunies par une ligne à microruban 44, elle même couplée à la ligne à microruban 45, dite "de couplage" de l'oscillateur 27. De manière très classique également dans les circuits en hyperfréquences, l'entrée 29 est reliée à la ligne à microruban 44 par l'intermédiaire d'un circuit de découplage hyperfréquence et basse-fréquence comportant une self de choc basse-fréquence 46, un piège quart d'onde hyperfréquence 47, et une ligne quart d'onde à haute impédance 48. On utilise classiquement deux varactors $D_3$ $D_4$ pour augmenter la linéarité de la pente de l'oscillateur 27.

Comme représenté sur le dessin, la ligne 45 est fermée à une de ses extrémités sur sa résistance d'adaptation 49, à travers une capacité de découplage 50, d'une valeur de quelques picofarads par exemple. Sur cette même extrémité est appliquée, à partir d'un point d'alimentation 51 et à travers un autre circuit de découplage comportant également une self de choc basse-fréquence 52, un piège quart d'onde 53, et une ligne quart d'onde 54, la tension continue de polarisation de la base 55 du transistor 56 de l'oscillateur 27.

La ligne à microruban 45 est couplée, comme il se doit, à un résonateur diélectrique $R_o$, de fréquence de résonance égale à la fréquence $F_o$ de l'oscillateur 27, c'est à dire 7 Gigahertz dans notre exemple.

Le transistor 56 (ou autre élément électronique actif adéquat, tel que transistor FET) a son collecteur relié à la masse par les vis de fixation 57 et la bride 58, tandis que son émetteur 59 est d'une part relié à une tension de polarisation continue, appliquée en 60 à travers la ligne quart d'onde 61, le piège 62 et la self de choc 63, et est d'autre part, à travers une nouvelle capacité de découplage 64, reliée à la ligne à microruban 42 de sortie, elle même connectée à son autre extrémité à la fiche de sortie 36 de l'oscillateur.

Conformément à un autre aspect de l'invention, le discriminateur de l'invention permet, par association avec un limiteur de niveau hyperfréquences, en soi totalement nouveau, qui sera décrit ci-dessous, ou d'un autre limiteur de niveau hyperfréquences de modèle connu, la réalisation directe d'un démodulateur hyperfréquences d'une onde hyperfréquence modulée en fréquence, cette fonction étant alors réalisée bien plus simplement qu'en fréquence intermédiaire comme cela se fait classiquement, et elle permet alors de s'affranchir avantageusement des problèmes bien connus de non-linéarité introduits, en fréquence intermédiaire, par les diodes "limiteuses" alors utilisées. Par ailleurs le limiteur hyperfréquences, tel que le limiteur d'un type nouveau qui sera décrit ci-après, peut jouer également le rôle de Commande Automatique de Gain, ce qui permet une simplification supplémentaire.

On se reportera donc maintenant à la figure 7 qui représente schématiquement un démodulateur en hyperfréquences d'une onde modulée en fréquence, conforme à l'invention.

L'onde hyperfréquences, à fréquence porteuse $F_o$ de 7 Gigahertz par exemple, modulée en fréquences dans une bande de 50 Megahertz par exemple, est appliquée en 70 au démodulateur de l'invention. Cette onde est appliquée sur l'entrée 71 d'un premier étage 72 de limiteur hyperfréquences d'un type nouveau, faisant par ailleurs également fonction de dispositif de Commande Automatique de Gain.

Ce limiteur 72 comporte un circulateur hyperfréquences 73, par exemple un circulateur à ferrite, à trois voies. Le signal est appliqué en 71 sur la première voie d'entrée. Il sort sur la sortie suivante 173, dans le sens de circulation, est appliqué, par la ligne 74, à l'entrée de commande en fréquence d'un oscillateur synchronisé classique 75, qui réémet donc, avec une puissance de sortie $P_s$ rigoureusement constante et fonction de l'oscillateur 75, une onde à fréquence $F_0 = 7$ Gigahertz sur la ligne 74 en direction du circulateur 73. Cette onde, de fréquence $F_0$ et de puissance $P_s$ définie, passe dans le circulateur 73, dans le sens de circulation schématisé par la flèche, et sort sur sa seconde sortie 76 sur la ligne 77 soit directement vers le discriminateur 78, soit plutôt, afin d'augmenter la dynamique de limitation et de Commande Automatique de Gain, vers un second limiteur 79, semblable au limiteur 72, mais de puissance de sortie supérieure. Sur la figure, on a schématisé plus que deux étages de limitation tels que 72 et 79, le dernier étage, qui définit la puissance d'attaque du discriminateur 78, ayant été figuré en pointillés en 80.

Un circuit 72 à oscillateur synchronisé 75 et circulateur 73 permet donc, conformément à l'invention, de constituer un limiteur de niveau hyperfréquences, limiteur qui fonctionne de surcroît en Commande Automatique de Gain. Il est à noter qu'un tel circuit 72 à circulateur 73 et oscillateur 75 est connu en soi, c'est-à-dire en tant que circuit, comme dispositif de synchronisation d'un oscillateur hyperfréquence synchronisé. L'invention consiste donc à utiliser ce circuit connu en tant que limiteur de niveau, et corrélativement Commande Automatique de Gain, en hyperfréquences.

Le signal compressé en sortie du dernier étage de limitation 80 est donc appliqué en 81 sur l'entrée du discriminateur 78 à résonateurs diélectriques, qui est un discriminateur par exemple tel que décrit précédemment en référence aux figures 2 et 3. La sortie S d'onde démodulée est appliquée, comme représenté, à un amplificateur de sortie, ladite onde basse-fréquence, directement démodulée sans passage en fréquence intermédiaire, étant alors recueillie en 83.

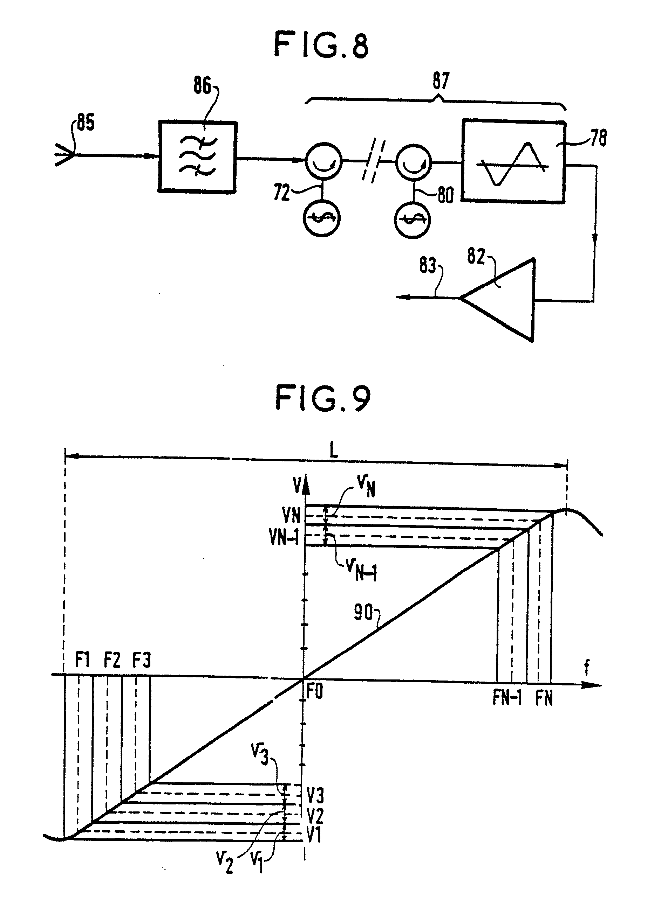

La figure 8 représente schématiquement un récepteur hyperfréquence à un seul canal, par exemple 7 Gigahertz ± 25 Mégahertz, conforme à l'invention.

Il comporte successivement, code on le voit sur le dessin :
- une arrivée 85 de l'onde hyperfréquence, en provenance de l'aérien-récepteur par exemple,
- un filtre de canal 86 accordé sur le canal à recevoir,
- un démodulateur hyperfréquences 87, identique à celui de la figure 7, qui ne sera donc pas décrit à nouveau ici,
- l'amplificateur basse-fréquence de sortie 82.

On se reportera maintenant à la figure 9 qui permet de faire comprendre un dernier aspect de l'invention permettant l'application d'un démodulateur de l'invention à la réalisation simple d'un récepteur multicanaux en hyperfréquences.

La figure 9 est le tracé de la caractéristique de réponse 90 tension (V)/ fréquences (f) d'un discriminateur hyperfréquences selon l'invention, centré sur la fréquence $f_0 = 7$ Gigahertz par exemple, et de largeur utile 4 égale à 2 Gigahertz par exemple.

Si l'on désire utiliser un tel discriminateur dans un modulateur équipant un récepteur multicanaux, on constate qu'il est possible de démoduler un très grand nombre de canaux. Dans l'exemple considéré par exemple, si chaque canal a une largeur en fréquences de 50 Mégahertz par exemple, le discriminateur considéré, de largeur utile en fréquences $L_a$ égale à 2 Gigahertz, permettra de démoduler 40 canaux adjacents successifs. Sur la figure 9, on a représenté ces canaux successifs : canal 1, canal 2, canal 3 ......, canal N-1, canal N, correspondant à des fréquences porteuses successives $F_1$, $F_2$, $F_3$ ....., $F_{n-1}$, $F_n$.

En sortie du démodulateur, à l'exception de la fréquence $F_0$, il apparaîtra pour chaque canal, comme on le voit sur la figure 9, une tension continue $V_1$, $V_2$, $V_3$, ...., $V_{n-1}$, $V_n$, qui se superposera à la tention alternative $v_1$, $v_2$, $v_3$, .....$v_{n-1}$, $v_n$ démodulée du canal 1, 2, 3, ...., N-1, N, correspondant.

Conformément à l'invention, on génère par ailleurs, en fonction de la fréquence $F_1$, $F_2$,....., $F_n$ du canal 1, 2, ....., N considéré, une tension continue correspondante $V_1$, $V_2$, .... $V_n$. Cette tension continue, $V_1$ par exemple est alors soustraite de la tension démodulée, $V_1 + v_1$ par exemple, correspondante, pour obtenir la tension basse-fréquence $v_1$. Selon une forme avantageuse de l'invention, cette tension continue, $V_1$ par exemple, est en outre utilisée pour effectuer la sélection automatique de la fréquence de canal, $F_1$ par exemple, à recevoir.

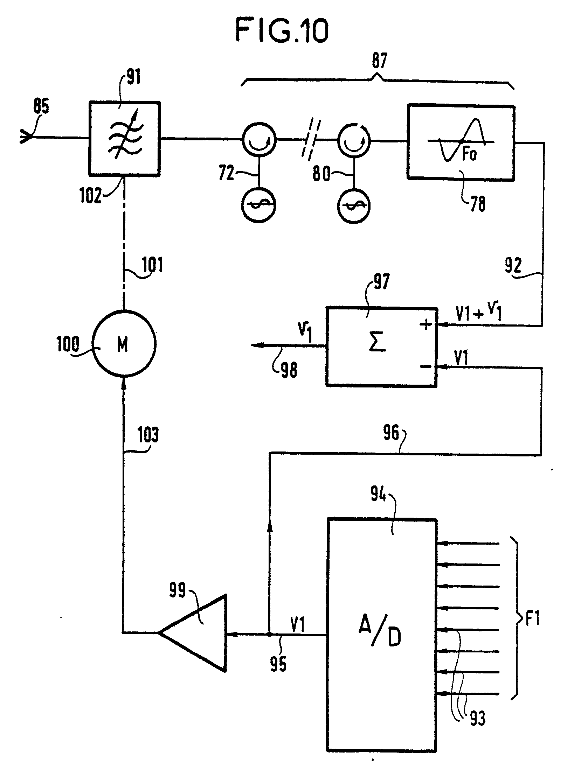

La figure 10 représente schématiquement un récepteur multicanaux fonctionnant tel qu'on vient de le définir.

On reconnaît, sur cette dernière figure, la ligne d'arrivée 85 du signal de canal en provenance de l'aérien récepteur. Ce signal passe dans un filtre de canal accordable mécaniquement 91, puis est appliqué à un démodulateur hyperfréquences 87 identique à celui décrit précédemment en référence à la figure 7. Celui-ci soit en 92 une tension démodulée égale, comme on vient de l'expliquer en référence à la figure 9, à la somme des tensions continue $V_1$ et alternative $v_1$ du canal reçu, à fréquence $F_1$ dans cet exemple.

Par ailleurs, un signal numérique, composé d'un octet représentatif de la fréquence $F_1$ à recevoir, est appliqué en parallèle sur les huit lignes 93 transmettant les 8 bits de l'octet, sur un convertisseur numérique-analogique 94 qui fournit sur sa sortie 95 une tension continue d'amplitude égale à V₁.

Cette tension V₁ en 95 est d'une part appliquée, par la ligne 96, à la borne négative d'un différentiateur analogique 97, sur la borne positive duquel est d'autre part appliquée, par la ligne 92, la tension démodulée $V_1 + v_1$ en sortie du démodulateur 87. On récupère donc, à la sortie 98 du soustracteur 97, la tension alternative basse-fréquence démodulée $v_1$. Par ailleurs, la tension continue $V_1$ en 95 est appliquée en 103, à travers un amplificateur de mise à niveau de puissance 99, à un moteur pas-à-pas à courant continu 100 dont l'arbre est relié mécaniquement, par un axe 101, à l'organe d'entrée mécanique de commande de réglage du filtre 91, le dispositif (100 à 103) étant réglé mécaniquement et électriquement pour que la tension, correspondante à $V_1$, appliquée en 103, fasse tourner le moteur 100 d'un angle qui positionne l'axe 101 de manière à ce que le filtre 91 sélectionne la fréquence $F_1$.

## Revendications

1. Discriminateur de fréquences pour onde en hyperfréquences comportant sur un même substrat (14) :
    - au moins une première ligne d'entrée à au moins un microruban (2) pour une onde hyperfréquences à discriminer,
    - au moins deux autres lignes secondaires à microruban (4, 5) disposées parallèlement de part et d'autre de la première ligne (2),
    - un couple de circuits de détection (D1, D2) formés respectivement de diodes hyperfréquences connectées en série-opposition ; caractérisé en ce que toutes les lignes (2, 4, 5) sont identiques, et de longueur approximativement égale à la moitié de la longueur d'onde (λo) du signal d'entrée, chaque ligne étant fermée à une extrémité par une résistance d'adaptation (3, 6, 7); en ce que ledit discriminateur comprend au moins un couple de résonateurs diélectriques hyperfréquences (Rl, R2) de fréquences de résonance (F₁, F₂) situées respectivement de part et d'autre de la fréquence (F₀) de l'onde hyperfréquence à discriminer ; un des résonateurs (R1) étant placé entre la ligne d'entrée (2) et l'une (4) des lignes secondaires, à proximité immédiate de celles-ci et couplé à celles-ci, un autre résonateur (R2) étant placé entre la ligne d'entrée (2) et une autre (5) ligne secondaire, à proximité immédiate de celles-ci et couplé à celles-ci ; et en ce que les diodes de détection hyperfréquence (D1, D2) sont connectées respectivement entre l'extrémité libre de chaque ligne secondaire (4, 5) et la masse, une résistance de charge (r1, r2) étant branchée entre ladite extrémité et la masse, la tension de sortie (S) d'onde hyperfréquence discriminée étant prise entre lesdites extrémités de ces lignes secondaires (4, 5).

2. Discriminateur selon la revendication 1, caractérisé en ce que chaque résonateur diélectrique (R₁, R₂), est associé à un dispositif de réglage de sa fréquence de résonance par plongeur métallique (15, 16) placé en regard dudit résonateur.

3. Discriminateur selon la revendication 2, caractérisé en ce que lesdits plongeurs métalliques (15, 16), sont montés chacun sur un dispositif à compensation mécanothermique (20, 21) tendant à stabiliser la fréquence de résonance de son résonateur associé lorsque la température varie.

4. Discriminateur selon l'une quelconque des revendications 1 à 3, caractérisé en ce qu'il est équipé d'au moins un couple de résonateurs diélectriques (R₁, R₂) composés chacun respectivement de matériau faisant varier en sens inverses leurs fréquences de résonance (F₁, F₂) lorsque la température varie.

5. Discriminateur selon la revendication 1, caractérisé en ce qu'il est par ailleurs placé dans une enceinte thermostatée.

6. Dispositif de Commande Automatique de Fréquence d'un oscillateur hyperfréquences (27) utilisant un discriminateur hyperfréquences, caractérisé en ce qu'il comporte :
    - un dispositif de couplage (31) d'ondes hyperfréquences placé en sortie dudit oscillateur (27),
    - un discriminateur hyperfréquences (33) à résonateurs diélectriques selon la revendication 1, de fréquence centrale (F₀) égale à celle dudit oscillateur, dont l'entrée est alimentée par la sortie (32) dudit dispositif de couplage, et dont la sortie (34) est reliée à une entrée (29) de commande de fréquence dudit oscillateur.

7. Dispositif de Commande Automatique de Fréquence selon la revendication 6, caractérisé en ce qu'il utilise un discriminateur hyperfréquences équipé d'au moins un couple de résonateurs diélectriques (R₁, R₂) dont les fréquences de résonance (F₁, F₂) varient en sens inverses lorsque la température varie.

8. Démodulateur d'onde hyperfréquences modulée en fréquence, utilisant un discriminateur hyperfréquences, caractérisé en ce qu'il comporte successivement :
   - un limiteur d'amplitude pour ondes hyperfréquences,
   - un discriminateur hyperfréquences à résonateurs diélectriques selon la revendication 1.

9. Démodulateur selon la revendication 8, caractérisé en ce que ledit limiteur d'amplitude comporte un élément, ou plusieurs éléments en série (72, 89,....., 80) comportant chacun :
   - un circulateur hyperfréquences (73) à au moins trois voies,
   - une entrée (71) de l'onde hyperfréquence à démoduler sur la borne d'entrée dudit circulateur,
   - une première sortie (173), dans le sens de circulation, dudit circulateur vers un oscillateur hyperfréquences synchronisé (75), ladite sortie formant entrée pour l'onde en retour dudit oscillateur syncronisé,
   - une deuxième sortie (76), placée après ladite première sortie dans le sens de circulation, dudit circulateur, formant sortie de l'onde hyperfréquences limitée en amplitude.

10. Récepteur pour onde hyperfréquence modulée en fréquence, caractérisé en ce qu'il comporte successivement :
    - un dispositif de filtrage (86) de l'onde à fréquence porteuse (F₁) que l'on vient recevoir,
    - un démodulateur hyperfréquences (87) selon la revendication 8 ou la revendication 9.

11. Récepteur multicanaux pour ondes hyperfréquences modulées en fréquence, caractérisé en ce qu'il comporte successivement :
    - un dispositif de filtrage (91) de l'onde à fréquence porteuse (F₁) que l'on veut recevoir,
    - un démodulateur hyperfréquences (87) selon la revendication 8 ou la revendication 9,
    - un dispositif (93, 94) de génération d'une tension continue (V₁) égale à la tension continue superposée, en sortie dudit démodulateur, à l'onde variable démodulée (v₁) transmise par l'onde à fréquence porteuse (F₁),
    - un dispositif (97) de soustraction de ladite tension continue (V₁) à la tension (V₁ + v₁) en sortie dudit démodulateur.

12. Récepteur multicanaux selon la revendication 11, caractérisé en ce qu'il est équipé de moyens (99 à 103) de sélection automatique de la fréquence (F₁) que l'on veut recevoir, à partir de ladite tension continue (V₁).

13. Récepteur multicanaux selon la revendication 12, caractérisé en ce qu'il est équipé de moyens (99 à 103) de commande automatique dudit dispositif de filtrage (91) par ladite tension continue (V₁).

## Claims

1. A microwave frequency discriminator comprising, on a common substrate (14):
   - at least one first inlet line (2) consisting of at least one microstrip, for a microwave to be discriminated,
   - at least two other secondary microstrip lines (4, 5) disposed parallelly on either side of the first line (2),
   - a pair of detector circuits (D1, D2) consisting respectively of microwave diodes connected in series-opposition, characterized in that all of the lines (2, 4, 5) are identical and have a length approximately equal to one half of the wavelength ($\lambda$ o) of the input signal, each line being terminated at one end by a matching resistance (3, 6, 7), that said discriminator comprises at least one pair of dielectric microwave resonators (R1, R2) having resonant frequencies (F₁, F₂) located respectively on either side of the frequency (Fo) of the microwave to be discriminated, one of the resonators (R1) being placed between the inlet line (2) and one (4) of the secondary lines in the immediate proximity of these lines and coupled thereto, whereas another resonator (R2) is placed between the inlet line (2) and another secondary line (5) in the immediate proximity of these lines and coupled thereto, and that the microwave detection diodes (D1, D2) are connected respectively between the free ends of each secondary line (4, 5) and mass, with a load resistance (r1, r2) being connected between said end and mass, and the output voltage (S) of the discriminated microwave being taken between said ends of said secondary lines (4, 5).

2. A discriminator according to claim 1, characterized in that each dielectric resonator ($R_1$, $R_2$) is associated with a device for controlling the resonant frequency by means of a metallic plunger (15, 16) placed facing said resonator.

3. A discriminator according to claim 2, characterized in that said metallic plungers (15, 16) are mounted respectively on a mechanothermal compensation device (20, 21) tending to stabilize the resonant frequency of the associated resonator with varying temperature.

4. A discriminator according to any one of the claims 1 to 3, characterized in that it is fitted with at least one pair of dielectric resonators ($R_1$, $R_2$) made respectively of materials adapted to vary the resonant frequencies ($F_1$, $F_2$) in opposite directions with changing temperature.

5. A discriminator according to claim 1, characterized in that it is further placed inside an enclosure whose temperature is thermostatically controlled.

6. An Automatic Frequency Control device for a microwave oscillator (27) using a microwave discriminator, characterized in that it comprises:
   - a microwave coupling device (31) placed at the output from said oscillator, and
   - a microwave discriminator (33) including dielectric resonators according to claim 1, having a center frequency (Fo) equal to the one of said oscillator, whose inlet is fed from the outlet (32) of said coupling device, and whose outlet (34) is connected to the frequency-controlling inlet (29) of said oscillator.

7. An Automatic Frequency Control device according to claim 6, characterized in that it uses a microwave discriminator fitted with at least one pair of dielectric resonators ($R_1$, $R_2$) whose resonant frequencies ($F_1$, $F_2$) vary in opposite directions with varying temperatures.

8. A frequency modulated microwave demodulator using a microwave discriminator, characterized in that it comprises:
   - a microwave amplitude limiter, and
   - a microwave discriminator including dielectric resonators according to claim 1.

9. A demodulator according to claim 8, characterized in that said amplitude limiter comprises one or more series-connected units (72, 89, ...80), each including:
   - a microwave circulator (73) having at least three channels,
   - a first input (71) for receiving the microwave to be demodulated at the input of said circulator,
   - a first output (173) in the direction of circulation of said circulator towards a synchronized microwave oscillator (75), said outlet forming the inlet for the returned wave from the synchronized oscillator, and
   - a second output (76) placed downstream from said first output in the direction of circulation of said circulator, forming the outlet for the microwave limited in amplitude.

10. A receiver for frequency modulated microwaves, characterized in that it comprises in succession:
   - a device (86) for filtering the carrier frequency wave ($F_1$), which has just been received, and
   - a microwave demodulator (87) as defined in claim 8 or in claim 9.

11. A receiver for frequency modulated microwaves, characterized in that it comprises in succession:
   - a device (91) for filtering the carrier frequency wave ($F_1$), which is to be received,
   - a microwave demodulator (87) as defined in claim 8 or in claim 9,
   - a device (93, 94) for generating a direct voltage ($V_1$) equal to the direct voltage which is superposed, at the output from said demodulator, on the demodulated variable voltage ($v_1$) transmitted by the carrier frequency wave ($F_1$), and
   - a device (97) for subtracting said direct voltage $V_1$ from the voltage ($V_1 + v_1$) at the output of said demodulator.

12. A multichannel receiver according to claim 11, characterized in that it is fitted with means (99 to 103) for automatically selecting the frequency $F_1$ which is to be received, using said direct voltage ($V_1$).

13. A multichannel receiver according to claim 12, characterized in that it is fitted with means for automatically controlling the filtering device (91) through said direct voltage ($V_1$).

## Ansprüche

1. Mikrowellenfrequenzdiskriminator, der auf einem gemeinsamen Substrat (14) aufweist
   - mindestens eine erste Eingangsleitung aus mindestens einem Mikrostreifen (2) für eine zu diskriminierende Mikrowelle,
   - mindestens zwei weitere Sekundärleitungen aus Mikrostreifen (4, 5) parallel zu beiden Seiten der ersten Leitung (2),
   - Detektorkreise (D1, D2), die aus zwei in Gegenrichtung gepolten und in Reihe verbundenen Mikrowellendioden bestehen, dadurch gekennzeichnet, daß alle Leitungen (2, 4, 5) gleich ausgebildet sind und eine Länge von annähernd der halben Wellenlänge ($\lambda$ o) des Eingangssignals besitzen, wobei jede Leitung an einem Ende durch einen Anpassungswiderstand (3, 6, 7) abgeschlossen ist, daß der Diskriminator mindestens ein Paar dielektrische Muikrowellenresonatoren (R1, R2) für Resonanzfrequenzen ($F_1$, $F_2$) aufweist, die zu beiden Seiten der Frequenz ($F_o$) der zu diskriminierenden Mikrowelle liegen, wobei einer der Resonatoren (R1) zwischen die Eingangsleitung (2) und eine der Sekundärleitungen (4) in unmittelbarer Nähe derselben angeordnet und an dieselben angekoppelt ist, während ein anderer Resonator (E2) zwischen die Eingangsleitung (2) und eine andere Sekundärleitung (5) in unmittelbarer Nähe derselben angeordnet und an dieselben angekoppelt ist, und daß die Mikrowellendetektordioden (D1, D2) je zwischen das freie Ende jeder Sekundärleitung (4, 5) und Masse geschaltet sind, wobei ein Lastwiderstand (r1, r2) zwischen das genannte Ende und Masse geschaltet ist und die Ausgangsspannung (S) der diskriminierten Mikrowelle zwischen diesen Enden der Sekundärleitungen (4, 5) abgenommen wird.

2. Diskriminator nach Anspruch 1, dadurch gekennzeichnet, daß jeder dielektrische Resonator (R1, R2) einer Vorrichtung zum Einstellen der Resonanzfrequenz mittels eines metallischen Stempels (15, 16), der sich gegenüber dem jeweiligen Resonator befindet, zugeordnet ist.

3. Diskriminator nach Anspruch 2, dadurch gekennzeichnet, daß die metallischen Stempel (15, 16) je an einer Vorrichtung mit mechanisch-thermischer Kompensation (20, 21) montiert sind, die bei Änderung der Temperatur die Stabilisierung der Resonanzfrequenz ihres zugehörigen Resonators bewirkt.

4. Diskriminator nach einem beliebigen der Ansprüche 1 bis 3, dadurch gekennzeichnet, daß er mit mindestens einem Paar dielektrischer Resonatoren (R1, R2) bestückt ist, die je aus einem Material bestehen, das bei Änderung der Temperatur die betreffenden Resonanzfrequenzen ($F_1$, $F_2$) im umgekehrten Sinn ändert.

5. Diskriminator nach Anspruch 1, dadurch gekennzeichnet, daß er in einem thermostatisch überwachten Gehäuse untergebracht ist.

6. Vorrichtung zur automatischen Frequenzsteuerung eines Mikrowellenoszillators (27), der einen Mikrowellendiskriminator verwendet, dadurch gekennzeichnet, daß sie aufweist
   - eine Vorrichtung (31) zur Ankopplung von Mikrowellen, die am Ausgang des Oszillators (27) angeordnet ist,
   - einen Mikrowellendiskriminator (33) mit dielektrischen Resonatoren gemäß Anspruch 1, deren Mittenfrequenz ($F_o$) gleich der Frequenz des Oszillators ist, wobei der Diskriminatoreingang über den Ausgang (32) der Ankoppelvorrichtung gespeist wird und der Ausgang (34) mit einem Frequenzsteuereingang (29) des Oszillators verbunden ist.

7. Vorrichtung zur automatischen Frequenzsteuerung nach An spruch 6, dadurch gekennzeichnet, daß sie einen Mikrowellendiskriminator verwendet, der mit mindestens einem Paar dielektrischer Resonatoren (R1, R2) versehen ist, deren Resonanzfrequenzen ($F_1$, $F_2$) sich bei Änderung der Temperatur im umgekehrten Sinn ändern.

8. Demodulator für frequenzmodulierte Mikrowellen, der einen Mikrowellendiskriminator verwendet, dadurch gekennzeichnet, daß er nacheinander aufweist
   - einen Amplitudenbegrenzer für Mikrowellen, und
   - einen Mikrowellendiskriminator mit dielektrischen Resonatoren gemäß Anspruch 1.

9. Demodulator nach Anspruch 8, dadurch gekennzeichnet, daß der Amplitudenbegrenzer ein Element oder mehrere in Reihe geschaltet Elemente (72, 89, ...80) besitzt, von denen jedes ausgestattet ist mit
   - einem Mikrowellenzirkulator (73), der mindestens drei Zugänge besitzt,

- einem Eingang (71) für die zu demodulierende Mikrowelle, der an den Eingang des Zirkulators führt,
- einem ersten Ausgang (173) in Umlaufrichtung des Zirkulators zu einem synchronisierten Mikrowellenoszillator (75), wobei dieser Ausgang für die rücklaufende Welle des synchronisierten Oszillators den Eingang bildet,
- einem zweiten Ausgang (76), der im Umlaufsinn des Zikulators hinter dem ersten Ausgang liegt und den Ausgang für die amplitudenbegrenzte Mikrowelle bildet.

10. Empfänger für eine frequenzmodulierte Mikrowelle, dadurch gekennzeichnet, daß er hintereinander aufweist
- eine Vorrichtung (86) zum Filtern der Trägerfrequenzwelle ($F_1$), die gerade empfangen wird, und
- einen Mikrowellendemodulator (87) gemäß Anspruch 8 oder Anspruch 9.

11. Mehrkanalempfänger für frequenzmodulierte Mikrowellen, dadurch gekennzeichnet, daß er hintereinander aufweist:
- eine Vorrichtung (91) zum Filtern der Trägerfrequenzwelle ($F_1$), die empfangen werden soll
- einen Mikrowellendemodulator (87) gemäß Anspruch 8 oder Anspruch 9,
- eine Vorrichtung (93, 94) zum Erzeugen einer Gleichspannung ($V_1$), die der Gleichspannung entspricht, welche am Ausgang des Demodulators der von der Welle mit Trägerfrequenz ($F_1$) übertragenen demodulierten veränderlichen Welle ($v_1$) überlagert ist,
- eine Vorrichtung (97) zum Subtrahieren dieser Gleichspannung ($V_1$) von der Spannung ($V_1 + v_2$) am Ausgang des Demodulators.

12. Mehrkanalempfänger nach Anspruch 11, dadurch gekennzeichnet, daß er mit Mitteln (99 bis 103) zur automatischen Wahl der Frequenz ($F_1$), die empfangen werden soll, auf der Basis dieser Gleichspannung ($V_1$) versehen ist.

13. Mehrkanalempfänger nach Anspruch 12, dadurch gekennzeichnet, daß er mit Mitteln (99 bis 103) zur automatischen Steuerung der Filtervorrichtung (91) durch die genannte Gleichspannung ($V_1$) versehen ist.

EP 0 190 613 B1

# FIG.1

# FIG.2

14

EP 0 190 613 B1

# FIG.3

15

# FIG.4

# FIG.5

## FIG.6

## FIG.7

EP 0 190 613 B1

# FIG.8

# FIG.9

18

# FIG.10